# EUROPÄISCHE PATENTANMELDUNG

(11) **EP 2 389 055 A2**
(43) Veröffentlichungstag der Anmeldung: **23.11.2011**
(21) Anmeldenummer: 11003677.9
(22) Anmeldetag: 05.05.2011
(51) Int. Cl.: H05K 7/14

(54) **Vorrichtung zur Befestigung von Geräten in Einrichtungen der Elektroinstallation**

(30) Priorität: 22.05.2010 DE 202010007186 U
(71) Anmelder: Hager Electro GmbH & Co. KG, 66440 Blieskastel (DE)
(72) Erfinder: Dissel, Klaus, 66131 Saarbrücken (DE); Gros, Bernhard, 57800 Betting (FR); Müller, Michael, 66271 Kleinblittersdorf (DE)
(74) Vertreter: Bernhardt, Reinold

(57) **Zusammenfassung**

Die Erfindung betrifft eine Vorrichtung zur Befestigung von Geräten in Einrichtungen der Elektroinstallation, insbesondere für die Befestigung von Zusatzgeräten (17) in Zähler- oder/und Verteilerschränken. Erfindungsgemäß ist eine an einer Installationswand (1) der Einrichtung anbringbare, an einander gegenüberliegenden Gehäuseseiten des zu befestigenden Gerätes (17) angreifende Halteklemme (4) vorgesehen.

## Beschreibung

Die Erfindung betrifft eine Vorrichtung zur Befestigung von Geräten in Einrichtungen der Elektroinstallation, insbesondere für die Befestigung von Zusatzgeräten in Zähleroder/und Verteilerschränken.

Die sich derzeit vollziehende Ablösung elektromechanischer Stromzähler durch elektronische Stromzähler (EHZ) bringt einen wachsenden Bedarf für die Installation zusätzlicher Geräte an Zählerplätzen mit sich. Vor allem werden Zusatzgeräte benötigt, die der Kommunikation mit den Stromversorgungsunternehmen dienen und z.B. eine Fernauslesung oder/und Fernsteuerung von Stromzählern, z.B. zwecks Tarifumstellung, ermöglichen. Zunehmend besteht auch Installationsbedarf für in einem Datennetz im Haus benötigte Geräte, insbesondere Multimediageräte.

Zur Montage von Zusatzgeräten, die keinen Platz auf Hutprofilschienen finden, werden herkömmlich Installationstafeln mit einer Vielzahl von Befestigungsbohrungen für eine Schraubbefestigung der Zusatzgeräte verwendet. Ein enges Bohrungsraster ermöglicht die Installation von Geräten unterschiedlicher Formen und Abmessungen.

Der Erfindung liegt die Aufgabe zugrunde, die Installation von Zusatzgeräten an Zählerplätzen und in Elektroverteilerschränken weiter zu vereinfachen.

Diese Aufgabe wird durch eine Vorrichtung gelöst, die durch eine an einer Installationswand der Elektroninstallationseinrichtung anbringbare, an gegenüberliegenden Gehäuseseiten des zu befestigenden Gerätes angreifende Halteklemme gekennzeichnet ist.

Vorteilhaft lässt sich mit Hilfe einer solchen Vorrichtung ein Zusatzgerät schnell und bequem, ggf. ohne Werkzeugeinsatz, innerhalb an einer Einrichtung der Elektroinstallation befestigen und ebenso problemlos aus der Befestigung lösen.

Vorzugsweise übt die Halteklemme eine elastische Klemmkraft auf die Gehäuseseiten aus. Vorteilhaft kann sich eine solche Halteklemme von selbst an unterschiedliche Geräteabmessungen anpassen.

Zweckmäßig ist die Halteklemme taschenartig ausgebildet und das Gerät, vorzugsweise von oben her, in die Halteklemme einschiebbar. Durch eine solche Halteklemme kann das Gerät bei verhältnismäßig geringer Klemmkraft dennoch zuverlässig einerseits form- und andererseits kraftschlüssig gehalten werden, wobei es insbesondere zwischen der Installationswand und zu der Installationswand im Abstand angeordneten Klemmschenkeln der Halteklemme zur Anordnung kommt.

In weiterer Ausgestaltung der Erfindung umfasst die Halteklemme Einrichtungen zur Aufhängung der Halteeinrichtung an der Installationswand, wobei die Installationswand zweckmäßig Halteeinrichtungen, vorzugsweise Einhänglöcher, in einer Rasteranordnung aufweist. Der Befestigungsort an der Installationswand kann so entsprechend der Ausdehnung der Rasteranordnung gewählt werden.

Vorzugweise ist die Halteklemme mit schmalen, die Gehäuseoberfläche weitgehend freilassenden Klemmschenkeln ausgebildet, die den Zugang zu Bedienelementen oder dergleichen kaum beeinträchtigen.

In einer bevorzugten Ausführungsform umfasst die Halteklemme zwei gebogene Blechsteifen, die durch Querstege miteinander verbunden sind, vorzugsweise zwei Querstege.

Die Halteklemme kann insbesondere eine Drahtkonstruktion aufweisen, und insbesondere an eine Gehäusevorderseite eingreifende Klemmschenkel können durch Drahtstücke gebildet sein.

An der Gerätevorderseite angreifende Klemmschenkel sind vorzugsweise S-förmig gebogen, insbesondere bei taschenartiger Ausbildung der Halteklemme. Das Gerät lässt sich so problemlos von oben in die Halteklemme einschieben, wobei die betreffenden Klemmschenkel mit einem S-Bogen auf das Gehäuse aufgleiten.

In weiterer Ausgestaltung der Erfindung weist die Halteklemme Einrichtungen, vorzugsweise Einhängeöffnungen, zum Anhängen einer weiteren Halteklemme auf. Auf diese Weise können mehrere Geräte kaskadenartig an der Installationswand angebracht werden.

Die Erfindung wird im Folgenden anhand von Ausführungsbeispielen und der beiliegenden, sich auf diese Ausführungsbeispiele beziehenden Zeichnungen weiter erläutert. Es zeigen:
- Fig. 1: eine erfindungsgemäße Vorrichtung mit einer Halteklemme,
- Fig. 2: die Vorrichtung von Fig. 1 mit einem an der Halteklemme angebrachten Zusatzgerät,
- Fig. 3 und 4: die Halteklemme von Fig. 1 und 2 in verschiedenen perspektivischen Ansichten,
- Fig. 5: die Halteklemme von Fig. 1 mit einer an dieser aufgehängten weiteren Halteklemme, und
- Fig. 6 und 7: ein weiteres Ausführungsbeispiel für eine erfindungsgemäße, weitgehend durch ein einziges Drahtstück gebildete Halteklemme.

Eine Vorrichtung zur Befestigung von Geräten in Einrichtungen der Elektroinstallation umfasst eine Installationsplatte 1, die eine Installationswand bildet und Befestigungslöcher 2 aufweist, durch die sie mit Halteschienen eines in einem Zähler- oder/und Verteilerschrank installierten Trägergestells (nicht gezeigt) verbunden werden kann. In einer Rasteranordnung sind über die Fläche der Installationstafel 1 Öffnungen 3 verteilt.

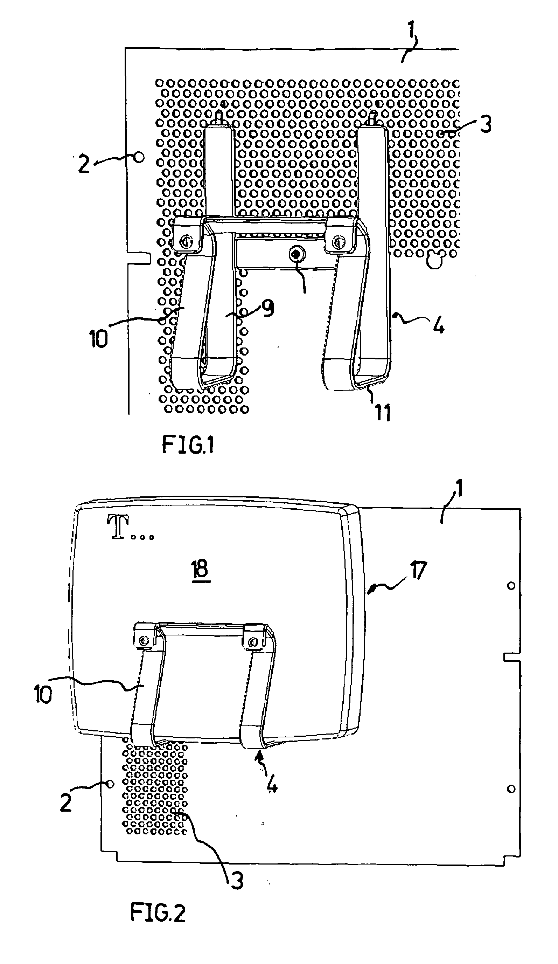

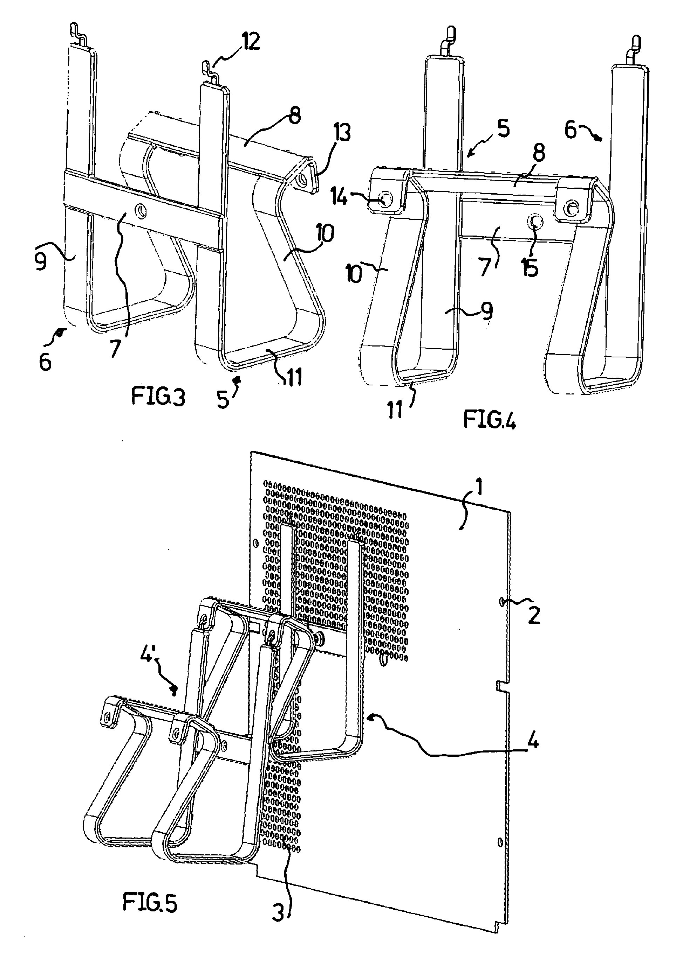

Wie aus Fig. 1 hervorgeht, lässt sich an der Installationswand 1 eine in den Figuren 3 und 4 gesondert dargestellte Halteklemme 4 anbringen, die in dem gezeigten Ausführungsbeispiel aus zwei gebogenen Blechstreifen 5 und 6 besteht. Die Blechstreifen sind durch zwei Querstege 7 und 8 miteinander verbunden.

Die Blechstreifen 5,6 weisen jeweils einen geraden Klemmschenkelabschnitt 9 und einen S-förmig gebogenen Klemmschenkelabschnitt 10 auf. Die Klemmenschenkelabschnitte 9,10 sind durch einen geraden Bodenabschnitt 11 des betreffenden Blechstreifens miteinander verbunden.

Jeder der Blechstreifen 5,6 ist an einem Ende mit einer zweifach in entgegengesetzten Richtungen abgewinkelten Zunge 12 zum Einhängen in eine der im Raster angeordneten Öffnungen 3 der Installationstafel 1 verbunden. Am anderen Ende weisen die Blechstreifen 5,6 in einer zu dem betreffenden Klemmschenkelabschnitt 9 etwa parallelen Endabwinklung 13 jeweils eine Durchgangsbohrung 14 auf. Eine weitere Durchgangsbohrung 15 ist in der Längsmitte des Querstegs 7 gebildet. Die Durchgangsbohrung 15 lässt sich wie Fig. 1 zeigt, zur Herstellung einer Schraubverbindung 16 zwischen der Halteklemme 4 und der Installationstafel 1 nutzen.

Wie aus Fig. 2 hervorgeht, kann die Halteklemme 4 z.B. ein der Telekommunikation dienendes Zusatzgerät 17 aufnehmen, wobei die Halteklemme 4 auf einander gegenüberliegende Seiten eines Gehäuses 18 des Zusatzgerätes 17 eine elastische Klemmkraft ausübt. In dem gezeigten Ausführungsbeispiel bildet die Halteklammer 4 eine Tasche, in welcher das Gerätegehäuse 18 mit einer unteren Schmalseite zur Auflage auf den geraden Bodenabschnitten 11 der Blechstreifen 5,6 kommt.

Die schmalen Klemmschenkelabschnitte 10 decken das Gerätegehäuse 18 nur zu einem geringen Anteil ab, so dass die Zugänglichkeit zu Bedien- oder Anzeigeelementen (nicht gezeigt) am Gerätegehäuse kaum beeinträchtigt ist.

Wie Fig. 5 erkennen lässt, sind die Durchgangsbohrungen 14 an den beiden Endabwinklungen 13 der Blechstreifen 5,6 bzw. Klemmschenkelabschnitte 10 zur Aufhängung einer weiteren Halteklemme 4' nutzbar. An der Installationstafel 1 können auf diese Weise mehrere Zusatzgeräte in kaskadenartiger Anordnung installiert werden.

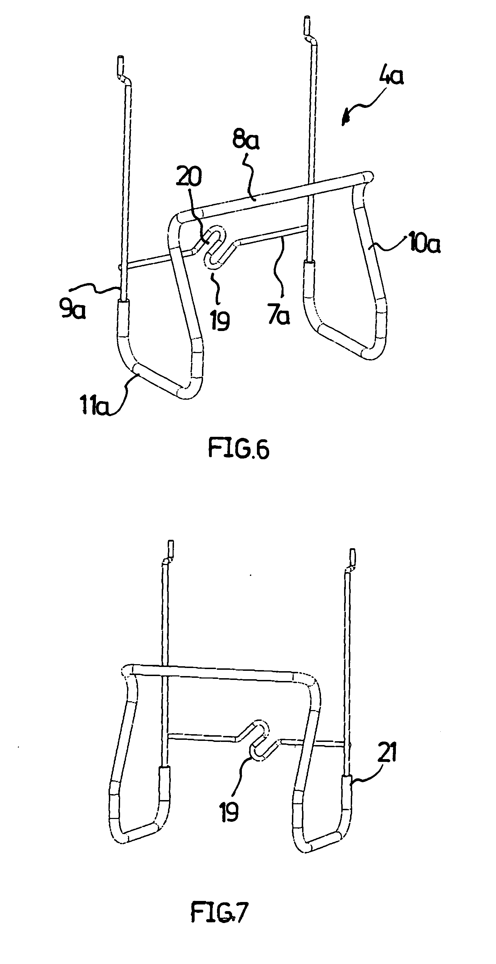

Ein in Fig. 6 und 7 gezeigtes Ausführungsbeispiel für eine Halteklemme 4a umfasst eine Drahtkonstruktion, wobei je zwei Klemmschenkelabschnitte 9a und 10α sowie ein die beiden Klemmschenkelabschnitte 10α verbindender Quersteg 8a durch Biegung aus einem einzigen Drahtstück hergestellt sind. Lediglich für einen die beiden Klemmschenkelabschnitte 9a verbindenden Quersteg 7a ist ein zweites Drahtstück verwendet. Der Quersteg 7a weist in seiner Längsmitte eine S-förmige Biegung 19 auf, die sich für eine Schraubverbindung mit einer Installationswand nutzen lässt. Durch die Biegung 19 sind vorteilhaft (einseitig offene) Langlöcher gebildet, welche eine Variation der Verbindungsstelle ermöglichen. Wie die Figuren 6 und 7 ferner erkennen lassen, ist die Halteklemme 4a teilweise mit einer weichen, die Gehäuseoberfläche schonenden Beschichtung 21 versehen.

## Patentansprüche

1. Vorrichtung zur Befestigung von Geräten in Einrichtungen der Elektroinstallation, insbesondere für die Befestigung von Zusatzgeräten (17) in Zähleroder/und Verteilerschränken,
**gekennzeichnet durch** eine an einer Installationswand (1) der Einrichtung anbringbare, an einander gegenüberliegenden Gehäuseseiten des zu befestigenden Gerätes (17) angreifende Halteklemme (4).

2. Vorrichtung nach Anspruch 1,
**dadurch gekennzeichnet,**
**dass** die Halteklemme (4) auf die Gehäuseseiten eine elastische Klemmkraft ausübt.

3. Vorrichtung nach Anspruch 1 oder 2,
**dadurch gekennzeichnet,**
**dass** die Halteklemme (4) taschenartig ausgebildet und das Gerät (17), vorzugsweise von oben her, in die Halteklemme (4) einschiebbar ist.

4. Vorrichtung nach einem der Ansprüche 1 bis 3,
**dadurch gekennzeichnet,**
**dass** die Halteklemme (4) Einrichtungen zur Aufhängung der Halteklemme (4) an Halteeinrichtungen (3) der Installationswand (1) umfasst.

5. Vorrichtung nach Anspruch 4,
**dadurch gekennzeichnet,**
**dass** die Installationswand (4) Halteeinrichtungen, vorzugsweise in Form von Öffnungen (3), in einer Rasteranordnung aufweist.

6. Vorrichtung nach einem der Ansprüche 1 bis 5,
**dadurch gekennzeichnet,**
**dass** die Halteklemme (4) schmale, die Gehäuseoberfläche weitgehend freilassende Klemmenschenkel (10) aufweist.

7. Vorrichtung nach Anspruch 6,
**dadurch gekennzeichnet,**
**dass** die Halteklemme (4a) eine Drahtkonstruktion aufweist.

8. Vorrichtung nach Anspruch 6 oder 7,
**dadurch gekennzeichnet,**
**dass** die Halteklemme (4,4α) zwei gebogene Blechstreifen (5,6) oder Drahtstücke umfasst, die durch Querstege, vorzugsweise zwei Querstege (7,8;7a,8a) miteinander verbunden sind.

9. Vorrichtung nach einem der Ansprüche 1 bis 8,
**dadurch gekennzeichnet,**
**dass** die Halteklemme (4) S-förmig gebogene Klemmschenkel (10) aufweist.

10. Vorrichtung nach einem der Ansprüche 1 bis 9,
**dadurch gekennzeichnet,**
**dass** die Halteklemme (4) Einrichtungen, vorzugsweise Durchgangsbohrungen (14), zum Anhängen einer weiteren solchen Halteklemme (4') aufweist.

11. Vorrichtung nach einem der Ansprüche 1 bis 10,
**dadurch gekennzeichnet,**
**dass** die Halteklemme eine weiche, die Gehäuseseiten schonende, ggf. ein Rutschen verhindernde Beschichtung (2) aufweist.
